# EUROPEAN PATENT APPLICATION

(11) **EP 3 115 416 A1**
(43) Date of publication of application: **11.01.2017**
(21) Application number: 14884871.6
(22) Date of filing: 21.05.2014
(51) Int. Cl.: C08L 63/00, C08G 59/42, C08K 5/10, C08L 25/06

(54) **THERMOSETTING RESIN COMPOSITION AND USE THEREOF**

(30) Priority: 03.03.2014 CN 201410074898
(71) Applicant: Shengyi Technology Co., Ltd., Guangdong 523808 (CN)
(72) Inventor: CHEN, Yong, Dongguan Guangdong 523808 (CN)
(74) Representative: Plougmann Vingtoft a/s
(86) International application number: PCT/CN2014/077994
(87) International publication number: WO 2015/131448

(57) **Abstract**

The present invention discloses a thermosetting resin composition, comprising an epoxy resin having two or more epoxy groups per resin molecule, and an active ester containing a styrene structure. The thermosetting resin composition is used for preparing resin sheet, resin composite metal copper foil, prepreg, laminate, copper-clad laminate and printed wiring board and so on. The thermosetting resin composition remarkably reduces the probability of delamination for PCB laminates, and the resulting resin composition has good thermal stability, heat and humidity resistance, a low dielectric constant and a low dielectric loss angle tangent, and good flame resistance.

## Description

### Technical field

The present invention relates to a resin composition, specifically a thermosetting resin composition and uses thereof in resin sheet, resin composite metal foil, prepreg, laminate, metal foil-clad laminate and printed wiring board.

### Background art

With the development of computers and information communication devices in the direction of high performance, high functionalization and networking in recent years, the operating signal tends to be high frequency, and new demands on the materials of the substrates used therefore are provided with the development of circuit substrates in the direction of high multilayer and high wiring density for the purpose of high speed transmission and high capacity information processing, including 1. good dielectric properties (i.e. low dielectric constant and low dielectric loss angle tangent), capable of maintaining stability within broader temperature range and frequency conditions; 2. being resistant to impacts of acid-alkaline, high temperature and high humidity during PCB processing, and having no hygroscopic expansion resulting in delamination; 3. being adapted to the technological demands on the processing and installing at high temperature; and 4. good flame retarding safety.

In the current materials used for printed circuit boards, however, the adhesives using epoxy resin as the main body are widely used. Common epoxy resin printed circuit board (FR-4 printed circuit board) has the main ingredients of low-bromine or high-bromine epoxy resins made of bisphenol A epoxy resins or tetrabromobisphenol A epoxy resins, in combination with curing agent dicyandiamide, solvents and catalysts. Although common epoxy resin printed circuit boards (FR-4 copper clad laminates) can meet most of the requirements on printed circuit boards, they have a low glass transition temperature (Tg) and a worse heat resistance, and higher dielectric constant and dielectric loss angle tangent (dielectric constant being 4.4 and dielectric loss angle tangent being about 0.02), insufficient high-frequency properties, so that they cannot meet the requirements on signal high-frequency. In order to meet the using demands as far as possible after the epoxy resin is cured, those skilled in the art modify epoxy resins with curing agents having an extremely low polarity, e.g. styrene maleic anhydride (SMA), or other curing agents having a low polarity, to increase high-frequency dielectric property and heat resistance. The following involves further discussions of these research results.

BE627887 discloses an epoxy resin composition using styrene maleic anhydride (SMA, having the following structural formula) as the epoxy resin crosslinking agent. Such epoxy resin composition has worse heat stability, and is not suitable for use in the substrate copper clad laminate of multilayer printed circuit boards.

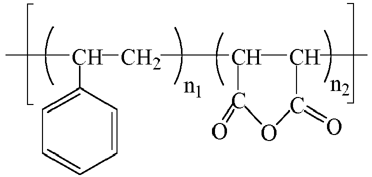

Common epoxy resin printed circuit board (FR-4 printed circuit board) has the main ingredients of low-bromine or high-bromine epoxy resins made of bisphenol A epoxy resins or tetrabromobisphenol A epoxy resins, in combination with curing agent dicyandiamide, solvents and catalysts, and has the shortcomings of low glass transition temperature Tg (120-140°C) and worser heat resistance. Those skilled in the art generally replace bifunctional epoxy resin with multifunctional epoxy resin, or replace dicyandiamide with phenolic resin, to increase the curing crosslinking density and the glass transition temperature and to improve the heat resistance. However, such method cannot improve the high frequency dielectric property of the sheets.

US6509414 discloses curing FR-4 epoxy resin by using styrene maleic anhydride copolymers as curing agent, tetrabromobisphenol A, tetrabromobisphenol A epoxy resin or a mixture thereof as co-curing agent, to increase the glass transition temperature and thermal stability. Styrene maleic anhydride in the composition is brittle, and the prepregs prepared therefrom (used for preparing printed circuit boards) are too crispy, so that the edge resin of the prepregs is easy to occur drylinting during the cutting, which is sometimes called "mushroom effect" and brings potential quality problems to the processing technology. In addition, there are two hydroxyl groups with high polarity in the molecular structure of tetrabromobisphenol A. The introduction of tetrabromobisphenol A deteriorates the dielectric performance of the system to some extent.

US6667107 discloses preparing a copper clad laminate composition having a low dielectric constant and dielectric loss angle tangent by using bifunctional cyanate and prepolymer thereof, styrene maleic anhydride and derivatives thereof, and epoxy resin. Although the copper clad laminate composition improves the glass transition temperature of the epoxy resin system by using cyanate resin and styrene maleic anhydride and derivatives thereof, and have excellent high-frequency dielectric properties, there are anhydride groups in the molecular structures of styrene maleic anhydride copolymers used in the system. Such anhydride groups may produce carboxyl groups having worse thermal stability and humidity resistance, and may make the humidity resistance deteriorate when being in combination with cyanates originally having a worse humidity resistance. Although the addition of epoxy resin will improve the humidity resistance to some extent, there is a limited improvement, and the deterioration cannot be eliminated. The sheets are easy to be etched by moisture to have delamination during the PCB manufacturing process, and the product yield is very low.

JP2003-252958 reveals a biphenyl epoxy resin and active ester composition. The composition after curing has excellent dielectric constant and dielectric loss angle tangent. However, since a bifunctional biphenyl epoxy resin is used, and the active ester has a low crosslinking density, cured product has the shortcomings of low glass transition temperature and lower heat resistance.

JP2009-235165 discloses curing epoxy resin with an active ester having the structural formula Y and having no styrene structure, which may obtain cured product having a higher glass transition temperature. 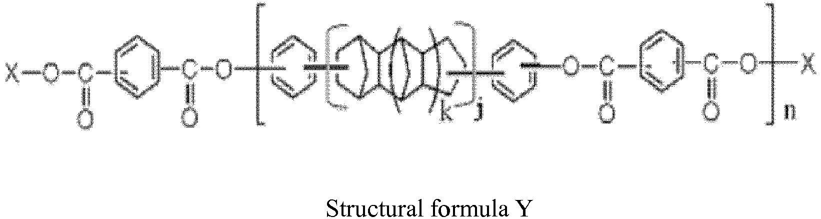 wherein X is a benzene ring or naphthalene ring; j is 0 or 1; k is 0 or 1; n represents that the average repeating unit is 0.25-1.25. In the application field having a harsher demand on the dielectric properties, the cured products of the active ester and epoxy resin need to further reduce the dielectric constant.

### Contents of the invention

In order to solve the aforesaid problems, one object of the present invention is to provide a thermosetting epoxy resin composition comprising an active ester containing a styrene structure. The resin composition has good humidity and heat resistance, a low dielectric constant and a low dielectric loss angle tangent, and good flame retardancy.

Another object of the present invention is to provide a prepreg and a printed wiring board prepared from thermosetting epoxy resin composition comprising an active ester containing a styrene structure, having good humidity and heat resistance, a low dielectric constant and a low dielectric loss angle tangent, high glass transition temperature, heat stability and good flame retardancy.

In order to achieve the aforesaid objects, the present invention, on one side, provides a thermosetting resin composition comprising an epoxy resin having two or more epoxy groups per resin molecule and an active ester containing a styrene structure.

Preferably, the epoxy resin in which each resin molecule has two or more epoxy groups is selected from the group consisting of, e.g. glycidyl ether epoxy resin, glycidyl ester epoxy resin, glycidyl amine epoxy resin, linear aliphatic epoxy resin, and alicyclic epoxy resin. Glycidyl ester epoxy resin is selected from the group consisting of, e.g. phthalic acid diglycidyl ester, tetrahydro-o-phthalic diglycidyl ester, and hexahydrophthalic acid diglycidyl ester. Glycidyl amine epoxy resin is selected from the group consisting of, e.g. 4,4-diaminodiphenylmethane tetra glycidyl amine (TGDDM) and triglycidyl p-aminophenol(TGPAP) and the like. Alicyclic epoxy resin is selected from the group consisting of, e.g. ERL-4221, ERL-4221D and ERL-4299 from DOW The epoxy resins can be used separately or in combination.

Preferably, the epoxy resin is one or a mixture of at least two selected from the group consisting of 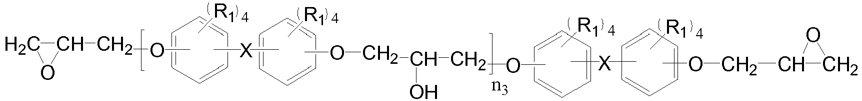 wherein R₁ is selected from the group consisting of hydrogen atom, halogen atom, substituted or unsubstituted C1-C8 linear-chain alkyl group, substituted or unsubstituted C1-C8 branched-chain alkyl group, substituted or unsubstituted alicyclic alkyl group, substituted or unsubstituted C1-C10 alkoxy group, and substituted or unsubstituted phenyl; n₃ is any natural number; X is anyone selected from the group consisting of -CH₂-, -O-, -CO-, -SO₂-, -S-, -CH(C₆H₅)-, -C(C₆H₅)₂-, -CH(CH₃)-, -C(CH₃)₂- or 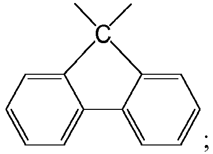 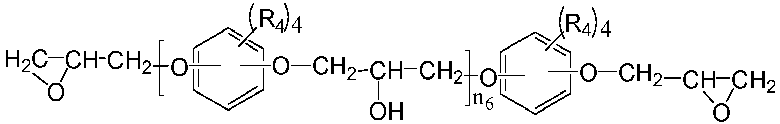 wherein R₄ is selected from the group consisting of hydrogen atom, halogen atom, substituted or unsubstituted C1-C8 linear-chain alkyl group, substituted or unsubstituted C1-C8 branched-chain alkyl group, substituted or unsubstituted alicyclic alkyl group, substituted or unsubstituted C1-C10 alkoxy group, and substituted or unsubstituted phenyl; n₆ is any natural number; and
phenol novolac epoxy resin, methyl phenol novolac epoxy resin, bisphenol-A novolac epoxy resin, dicyclopentadiene epoxy resin, biphenyl epoxy resin, resorcinol epoxy resin, naphthalene epoxy resin, phosphorous-containing epoxy resin, silicon-containing epoxy resin, glycidyl amine epoxy resin, alicyclic epoxy resin, polyethylene glycol epoxy resin, tetraphenol ethane tetraglycidyl ether, and triphenolmethane epoxy resin. The mixture is selected from the group consisting of, e.g. a mixture of methyl phenol novolac epoxy resin and tetraphenol ethane tetraglycidyl ether, a mixture of triphenolmethane epoxy resin and polyethylene glycol epoxy resin, a mixture of resorcinol epoxy resin and alicyclic epoxy resin, a mixture of naphthalene epoxy resin and biphenyl epoxy resin, and a mixture of bisphenol-F epoxy resin and bisphenol-A epoxy resin.

Preferably, the epoxy resin is one or a mixture of at least two selected from the group consisting of 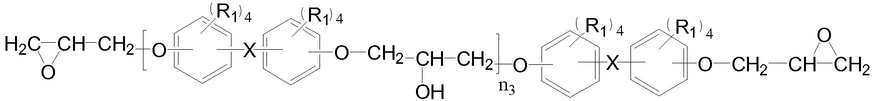 wherein R₁ is selected from the group consisting of hydrogen atom, halogen atom, substituted or unsubstituted C1-C8 linear-chain alkyl group, substituted or unsubstituted C1-C8 branched-chain alkyl group, substituted or unsubstituted alicyclic alkyl group, substituted or unsubstituted C1-C10 alkoxy group, and substituted or unsubstituted phenyl; n₃ is any natural number; X is anyone selected from the group consisting of -CH₂-, -O-, -CO-, -SO₂-, -S-, -CH(C₆H₅)-, -C(C₆H₅)₂-, -CH(CH₃)-, -C(CH₃)₂- or 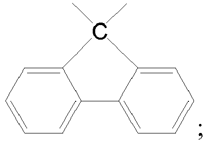 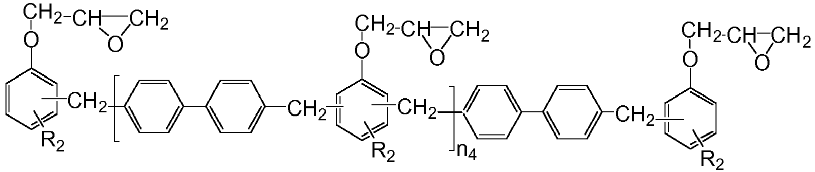 wherein R₂ is selected from the group consisting of hydrogen atom, substituted or unsubstituted C1-C8 linear-chain alkyl group, substituted or unsubstituted C1-C8 branched-chain alkyl group, substituted or unsubstituted alicyclic alkyl group, substituted or unsubstituted C1-C10 alkoxy group, and substituted or unsubstituted phenyl; 0≤n₄≤20, and n₄ is an integer; 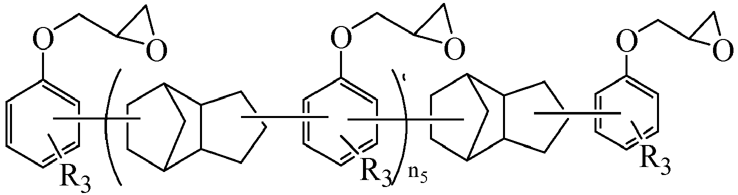 wherein R₃ is selected from the group consisting of hydrogen atom, substituted or unsubstituted C1-C8 linear-chain alkyl group, substituted or unsubstituted C1-C8 branched-chain alkyl group, substituted or unsubstituted alicyclic alkyl group, substituted or unsubstituted C1-C10 alkoxy group, and substituted or unsubstituted phenyl; 0≤n₅≤20, and n₅ is an integer; 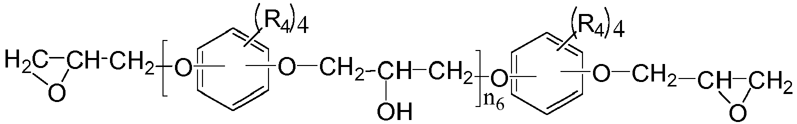 wherein R₄ is selected from the group consisting of hydrogen atom, substituted or unsubstituted C1-C8 linear-chain alkyl group, substituted or unsubstituted C1-C8 branched-chain alkyl group, substituted or unsubstituted alicyclic alkyl group, substituted or unsubstituted C1-C10 alkoxy group, and substituted or unsubstituted phenyl; n₆ is any natural number; and 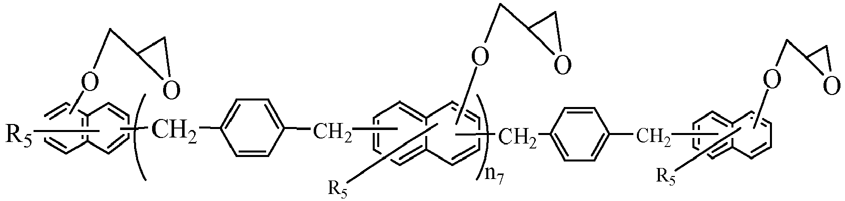 wherein R₅ is selected from the group consisting of hydrogen atom, substituted or unsubstituted C1-C8 linear-chain alkyl group, substituted or unsubstituted C1-C8 branched-chain alkyl group, substituted or unsubstituted alicyclic alkyl group, substituted or unsubstituted C1-C10 alkoxy group, and substituted or unsubstituted phenyl; 0≤n₇≤20, and n₇ is an integer.

Preferably, the active ester containing a styrene structure has the following structure: 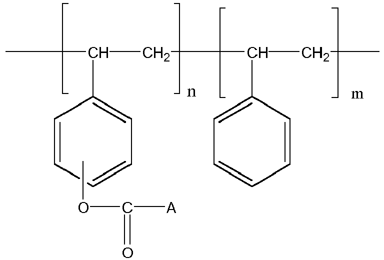 wherein A is selected from the group consisting of substituted or unsubstituted phenyl, substituted or unsubstituted naphthyl and C1-C8 alkyl; m and n are natural numbers; m/n=0.8-19. When m/n is higher than 19, the sheets have a too low peel strength to easily result in potential quality problems, such as broken thread, during the manufacturing process of PCB; when m/n is less than 0.8, the dielectric properties of the sheets will be deteriorated. In consideration of the balance of dielectric constant, dielectric loss angle tangent, glass transition temperature, dip soldering property and peel strength, m/n is preferably 1-8.

Preferably, in consideration of the balance of dielectric constant, dielectric loss tangent, glass transition temperature, dip soldering property and peel strength, the active ester is in an amount of from 10 to 70 wt.%, preferably from 15 to 65wt.%, further preferably from 15 to 60wt.%, of the total weight of the thermosetting resin composition, e.g. 11wt.%, 15wt.%, 17wt.%, 19wt.%, 23wt.%, 25wt.%, 27wt.%, 29wt.%, 35wt.%, 37wt.%, 40wt.%, 45wt.%, 50wt.% and 55wt.%.

Preferably, the composition of the present invention further comprises a flame retardant, preferably halogen flame retardant or/and phosphorus flame retardant.

Preferably, the halogen flame retardant is one or a mixture of at least two selected from the group consisting of brominated phenol, brominated bisphenol A, decabromodiphenyl ether, brominated polystyrene, brominated polycarbonate, decabromodiphenylethane or ethylene-bis(tetrabromo-phthalimide). The mixture is selected from the group consisting of, e.g. a mixture of ethylene-bis(tetrabromophthalimide) and decabromodiphenylethane, a mixture of brominated polycarbonate and hexabromobenzene, a mixture of decabromodiphenyl ether and ethylene-bis(tetrabromophthalimide), a mixture of decabromodiphenylethane and brominated polycarbonate. The brominated flame retardant may be used separately or in combination.

Preferably, the phosphorous flame retardant is anyone or a mixture of at least two selected from the group consisting of tri-(2,6-dimethylphenyl)phosphine, tetrakis(2,6-dimethylphenyl) 1,3-phenylene bisphosphate, tetraphenyl resorcinol diphosphate, triphenyl phosphate, bisphenol A-bis(diphenyl phosphate), phosphonitrile flame retardant, 10-(2,5-dihydroxylphenyl)-10-hydro-9-oxa-10-phosphaphenanthrene-10-oxide, 10-(2,5-dihydroxylnaphthyl)-10-hydro-9-oxa-10-phosphaphenanthrene-10-oxide or 9,10-dihydro-9-oxa-10-phosphaphenanthrene-10-oxide flame retardant.

The inorganic flame retardant used in combination with the additive organic flame retardant is one or a mixture of at least two selected from the group consisting of red phosphorus, aluminum hydroxide, magnesium hydroxide and antimony trioxide. The mixture is selected from the group consisting of, e.g. a mixture of antimony trioxide and magnesium hydroxide, a mixture of aluminum hydroxide and red phosphorus, a mixture of antimony trioxide and aluminum hydroxide, a mixture of magnesium hydroxide and red phosphorus, a mixture of antimony trioxide, magnesium hydroxide and aluminum hydroxide, and a mixture of red phosphorus, antimony trioxide, magnesium hydroxide and aluminum hydroxide.

Preferably, the additive flame retardant is in an amount of from 5 to 30 wt.%, e.g. 7wt.%, 9wt.%, 11wt.%, 13wt.%, 15wt.%, 17wt.%, 19wt.%, 21wt.%, 23wt.%, 25wt.%, 27wt.%, 29wt.%, preferably from 10 to 30wt.%, more preferably from 10 to 25wt.%, of the total weight of the thermosetting resin composition.

Preferably, the thermosetting resin further comprises a filler.

Preferably, the filler is anyone or a mixture of at least two selected from the group consisting of aluminium hydroxide, magnesium hydroxide, kaolin, talc, hydrotalcite, calcium silicate, beryllia, boron nitride, glass powder, silica powder, zinc borate, aluminium nitride, silicon nitride, silicon carbide, magnesium oxide, zirconium oxide, mullite, titanium oxide, potassium titanate, hollow glass beads, potassium titanate fibers, silicon carbide monocrystal fibers, silicon nitride fibers, aluminium oxide monocrystal fibers, glass short fibers, polytetrafluoroethylene powder, polyphenylene sulfide powder, and polystyrene powder. The mixture is selected from the group consisting of, e.g. a mixture of aluminium hydroxide and magnesium hydroxide, a mixture of kaolin and hydrotalcite, a mixture of calcium silicate and beryllia, a mixture of boron nitride and glass powder, a mixture of silica powder and zinc borate, a mixture of aluminium nitride and silicon nitride, a mixture of silicon carbide and magnesium oxide, a mixture of zirconium oxide and mullite, a mixture of titanium oxide and potassium titanate, a mixture of hollow glass beads and potassium titanate fibers, a mixture of silicon carbide monocrystal fiber and silicon nitride monocrystal fibers, a mixture of aluminium oxide monocrystal fibers and glass short fibers, a mixture of polytetrafluoroethylene powder and polyphenylene sulfide powder. The filler may be used separately or in combination.

Preferably, the filler is in an amount of from 5 to 60 wt.% of the total weight of the thermosetting resin composition, e.g. 12wt.%, 15wt.%, 18wt.%, 21wt.%, 25wt.%, 27wt.%, 32wt.%, 35wt.%, 38wt.%, 42wt.%, 45wt.%, 48wt.%, 52wt.%, 54wt.%, 56wt.%, 58wt.%, preferably from 15 to 55wt.%, further preferably from 20 to 40wt.%.

The thermosetting resin composition of the present invention may comprise a catalyst.

Preferably, the catalyst is one or a mixture of at least two selected from the group consisting of tertiary amine, tertiary phosphine, quaternary ammonium salt, quaternary phosphonium salt or imidazole compound

Preferably, the tertiary amine is anyone or a mixture of at least two selected from the group consisting of triethylamine, tributylamine, dimethylaminoethanol, N,N-dimethyl-pyridylamine or benzyldimethylamine.

Preferably, the tertiary phosphine is selected from the group consisting of triphenylphosphine and trialkylphosphine.

Preferably, the quaternary ammonium salt is anyone or a mixture of at least two selected from the group consisting of tetramethyl ammonium bromide, tetramethyl ammonium chloride, tetramethyl ammonium iodide, benzyl trimethyl ammonium chloride, benzyl triethyl ammonium chloride or cetyltrimethyl ammonium bromide. The mixture is selected from the group consisting of, e.g. a mixture of cetyltrimethyl ammonium bromide and benzyl triethyl ammonium chloride, a mixture of benzyl trimethyl ammonium chloride and tetramethyl ammonium iodide, a mixture of tetramethyl ammonium chloride and tetramethyl ammonium bromide, a mixture of cetyltrimethyl ammonium bromide, benzyl triethyl ammonium chloride and benzyl trimethyl ammonium chloride, a mixture of tetramethyl ammonium iodide, tetramethyl ammonium chloride and tetramethyl ammonium bromide.

Preferably, the quaternary phosphonium salt is anyone or a mixture of at least two selected from the group consisting of tetrabutylphosphonium chloride, tetrabutylphosphonium bromide, tetrabutyl- phosphonium iodide, tetraphenylphosphonium chloride, tetraphenylphosphonium bromide, tetraphenylphosphonium iodide, ethyltriphenylphosphonium chloride, propyltriphenylphosphonium chloride, propyltriphenylphosphonium bromide, propyltriphenylphosphonium iodide, butyltriphenylphosphonium chloride, butyltriphenylphosphonium bromide or butyltriphenylphosphonium iodide. The mixture is selected from the group consisting of, e.g. a mixture of butyltriphenylphosphonium chloride and propyltriphenylphosphonium bromide, a mixture of propyltriphenylphosphonium chloride and ethyltriphenylphosphonium chloride, a mixture of tetrabutylphosphonium iodide and tetrabutylphosphonium bromide, a mixture of tetraphenylphosphonium chloride and tetrabutylphosphonium iodide, a mixture of tetrabutylphosphonium bromide and tetrabutylphosphonium chloride, and a mixture of butyltriphenylphosphonium chloride, propyltriphenylphosphonium chloride and tetraphenylphosphonium iodide.

Preferably, the imidazole compound is one or a mixture of at least two selected from the group consisting of 2-methylimidazole, 2-ethyl-4-methylimidazole, 2-phenylimidazole, 2-undecylimidazole, 1-benzyl-2- methylimidazole, 2-heptadecylimidazole, 2-isopropylimidazole, 2-phenyl-4- methylimidazole, 2-dodecylimidazole or cyanoethyl-2-methylimidazole. The mixture is selected from the group consisting of, e.g. a mixture of cyanoethyl-2-methylimidazole and 2-phenyl-4-methylimidazole, a mixture of 2-isopropylimidazole and 2-heptadecylimidazole, a mixture of 1-benzyl-2- methylimidazole and 2-undecylimidazole, a mixture of 2-phenylimidazole and 2-ethyl-4-methylimidazole, a mixture of 2-methylimidazole and 2-heptadecylimidazole.

The amount of the catalyst used is determined by the types of epoxy resins, curing agents and catalysts. One principle for using the catalyst is that the gelation time of the varnish shall not be less than 120s. The catalyst in the present invention is in an amount of from 0.001 to 5.0 wt.%, preferably from 0.05 to 4.0 wt.%, more preferably from 0.05 to 3.0 wt.%, of the total weight of the thermosetting resin composition. If the amount of the catalyst is too high (more than 5.0 wt.%), the epoxy resin composition has a too fast reactivity to have adverse effects on the production of the by-product and the conversion rate homogeneity of the curing reaction. If the amount thereof is less than 0.001 wt.%, the reactivity is too slow to be advantageous to the production of the prepregs.

Into the thermosetting resin composition of the present invention may be added a catalyst.

Preferably, the thermosetting resin composition further comprises a solvent selected from the group consisting of ketones, hydrocarbons, ethers or aprotic solvents, or a mixture of at least two selected therefrom, preferably anyone or a mixture of at least two selected from acetone, methylethyl ketone, methylisobutyl ketone, toluene, xylol, methanol, ethanol, primary alcohol, ethylene glycol monomethyl ether, propylene glycol monomethyl ether, ethyl acetate, N,N-dimethylformamide, or N,N-diethylformamide. The solvent may be used separately or in combination. The addition amount of the solvent may be determined by those skilled in the art according to the viscosity of the resin to be used, so as to make the resultant epoxy resin varnish have a suitable viscosity and convenient for curing. The present invention will not define the amount thereof.

Preferably, the thermosetting resin composition further comprises one or a mixture of at least two selected from the group consisting of polyphenylether, cyanate resin or BT resin.

Preferably, the cyanate resin is prepared from anyone or a mixture of at least two selected from the following monomers, from anyone or a mixture of at least two selected from the prepolymers of the following monomers, or a mixture of at least two selected therefrom: bisphenol A cyanate, 2,2-di(cyanatephenyl)-propane, di(cyanatephenyl)ethane, di(cyanatephenyl)methane, di(4-cyanate-3,5-dimethylphenyl)methane, 2,2-di(4-cyanatephenyl)hexafluoro-propane, di(4-cyanatephenyl)thioether, novolac cyanate or cyanate containing dicyclopentadiene structure.

Preferably, the thermosetting resin composition may further comprise polyphenylether(PPO).

Preferably, the thermosetting resin composition may further comprise rubbers or rubber-modified compounds, such as styrene/butadiene copolymers, copolymers of butadiene/styrene and methyl methacrylate or other ethylene compounds, rubber nuclear shell particles of methyl methacrylate/butadiene/styrene or epoxy resin modified thereby, epoxy or phenoxy resins modified by rubbers, such as CTBN and the like.

Preferably, the thermosetting resin composition further comprises anyone or a mixture of at least two selected from the group consisting of dyes, pigments, surfactants, leveling agents and ultraviolet light absorbers.

The second aspect of the present invention provides resin sheet, resin composite metal foil, prepreg, laminate, copper-clad laminate and printed wiring board prepared by the thermosetting resin composition.

The third aspect of the present invention provides use of the thermosetting resin composition in the preparation of resin sheet, resin composite metal foil, prepreg, laminate, copper-clad laminate and printed wiring board.

The processes for preparing the resin sheet by using the thermosetting resin composition of the present invention are listed as follows, but the processes for preparing the resin sheet are not limited thereto. The aforesaid thermosetting resin composition is coated on the carrier film, which may be polyester film or polyimide film, having a thickness of 5-150µm, e.g. 10µm, 15µm, 20µm, 25µm, 30µm, 35µm, 40µm, 45µm, 50µm, 55µm, 60µm, 70µm, 80µm, 90µm, 100µm, 105µm, 110µm and 115µm. Then the carrier film coated with the thermosetting resin composition is heated at a temperature of 100-250°C (e.g. 110°C, 120°C, 130°C, 140°C, 150°C, 160°C, 170°C, 180°C, 190°C, 200°C, 210°C, 220°C and 240°C) for 10second-30min, to form sheets, e.g. 30s, 60s, 3min, 5min, 8min, 11min, 15min, 18min, 21min, 24min, 27min, 29min. The formed resin sheet has a thickness of 5-100µm, e.g. 10µm, 15µm, 20µm, 25µm, 30µm, 35µm, 40µm, 45µm, 50µm, 55µm, 60µm, 70µm, 80µm, and 90µm.

The processes for preparing the resin composite metal foil by using the thermosetting resin composition of the present invention are listed as follows, but the processes for preparing the resin composite metal foil are not limited thereto. The metal foil may be one or a mixture of at least two selected from the group consisting of copper, brass, aluminium or nickel, or alloys containing said metals. The metal foil has a thickness of 5-150µm, e.g. 10µm, 15µm, 20µm, 25µm, 30µm, 35µm, 40µm, 45µm, 50µm, 55µm, 60µm, 70µm, 80µm, 90µm, 100µm, 105µm, 110µm and 115µm. The thermosetting resin composition is coated by the manual or mechanical roller means onto the metal foil. Then such metal foil coated with thermosetting resin composition is heated and dried to make the thermosetting resin composition in the semi-curing state (B-Stage), and then heated at a temperature of 100-250°C (e.g. 110°C, 120°C, 130°C, 140°C, 150°C, 160°C, 170°C, 180°C, 190°C, 200°C, 210°C, 220°C, 240°C) for 10 seconds-30min (e.g. 30s, 60s, 3min, 5min, 8min, 11min, 15min, 18min, 21min, 24min, 27min, 29min), and cured, to finally form a resin coated metal having a thickness of 1-150µm. The resin coated copper(RCC) obtained thereby may be used as internal or external layers for adding layer to the printed circuit boards.

The processes for preparing prepreg by using the thermosetting resin composition of the present invention are listed as follows, but the processes for preparing prepreg are not limited thereto. The thermosetting resin composition is impregnated onto reinforcing material, and the prepreg impregnated with the thermosetting resin composition is heated and dried to make the thermosetting resin composition in the prepreg in the semi-curing phase (B-Stage), so as to obtain a prepreg. The heating temperature ranges 80 to 250°C, e.g. 90°C, 100°C, 110°C, 120°C, 130°C, 140°C, 150°C, 160°C, 170°C, 180°C, 190°C, 200°C, 210°C, 220°C, 230°C, and 240°C. The heating lasts for 1-30min, e.g. 3min, 5min, 7min, 10min, 13min, 16min, 19min, 22min, 25min, 28min and 29min. The reinforcing materials used therein may be inorganic or organic materials. Inorganic materials include, for examples, woven fabrics of glass fibers, carbon fibers, boron fibers, metals, or non-woven fabrics or paper, wherein the glass fabrics or non-woven fabrics may be E-glass, Q-model fabric, NE fabric, D-model fabric, S-model fabric, high silica fabric and the like. Organic fibers include, for example, woven fabrics prepared from polyesters, polyamines, polyacrylic acid, polyimide, aramid fiber, polytetrafluoroethylene and syndiotactic polystyrene, or non-woven fabrics or paper. However, the reinforcing materials are not limited thereto. Other reinforcing materials for resin reinforcing can also achieve the present invention. The prepreg contains resin in an amount of 25-70wt.%.

The aforesaid resin sheet, resin composite metal foil and prepreg can be used for preparing laminate, copper-clad laminate and printed wiring board.

The process for preparing laminate using the prepreg of the present invention is stated as follows: overlaying at least two sheets of the prepregs, hot-pressing at 130-250°C and a pressure of 3-50kgf/cm² for 60-240 min to form laminate, so as to obtain the laminate. The hot-pressing temperature ranges from 130 to 250°C, e.g. 140°C, 150°C, 160°C, 170°C, 180°C, 190°C, 200°C, 210°C, 220°C, 230°C and 240°C. The pressure ranges from 3 and 50kgf/cm², e.g. 5kgf/cm², 8kgf/cm², 11kgf/cm², 14kgf/cm², 17kgf/cm², 24kgf/cm², 28kgf/cm², 32kgf/cm², 37kgf/cm², 42kgf/cm², 45kgf/cm², 48kgf/cm². The hot pressing time ranges 60 to 240min, e.g. 70min, 90min, 110min, 130min, 150min, 170min, 190min, 210min, 230min, and 240min.

The process for preparing metal foil-clad laminate by using the prepreg of the present invention is as follows: cutting one or more prepregs into a certain size, laminating and feeding into a laminating device for lamination; placing metal foil at one or both sides of the prepreg at the same time; pressing the prepreg by thermo-compression molding into metal foil-clad laminate. The metal foil may be one or a mixture of at least two selected from the group consisting of copper, brass, aluminium or nickel, or alloys containing said metal. As the pressing conditions of the laminate, the suitable laminating curing conditions may be chosen according to the actual situation of the epoxy resin composition. If the pressing pressure is too low, there will be voids in the laminate, and the electrical properties thereof will be reduced. If the lamination pressure is too high, there will be too much internal stress in the laminates, so as to reduce the size stability of the laminates, all of which need to press the sheet with a suitable pressure satisfying the molding to achieve the requirements. The general guiding principles for pressing laminate comprise a laminating temperature of 130-250°C, a pressure of 3-50kgf/cm², and a hot pressing time of 60-240min. The hot pressing temperature ranges from 130 to 250°C, e.g. 140°C, 150°C, 160°C, 170°C, 180°C, 190°C, 200°C, 210°C, 220°C, 230°C and 240°C. The pressure ranges from 3-50 kgf/cm², e.g. 5kgf/cm², 8kgf/cm², 11kgf/cm², 14kgf/cm 2, 17kgf/cm², 24kgf/cm², 28kgf/cm², 32kgf/cm², 37kgf/cm², 42kgf/cm², 45kgf/cm² and 48kgf/cm². The thermo-compression lasts for 60-240min, e.g. 70min, 90min, 110min, 130min, 150min, 170min, 190min, 210min, 230min and 240min.

Printed wiring boards or complex multiplayer printed circuit boards can be prepared from resin sheet, resin composite metal foil, prepreg and metal foil-clad laminate by addition or subtractive process. By using the prepreg of the present invention, the process for preparing printed wiring board is stated as follows: preparing by the aforesaid process to obtain metal foil-clad laminate, preparing printed wiring board or complex multilayer printed circuit board by additive or subtractive process.

The thermosetting resin composition varnish is the liquid varnish obtained by adding the solvent into the composition and adjusting the solvent.

Besides resin sheet, resin composite metal foil, prepreg, laminate, metal foil-clad laminate, and printed wiring board, the thermosetting resin composition of the present invention can also be used for preparing adhesives, coatings, buildings, aviation, shipping, and automobile industry.

The wording "comprise(s)/comprising" in the present invention means that, besides said components, there may be other components which endow the resin composition with different properties. No matter which components the thermosetting resin composition comprises, the sum of the mass percent of each component in the thermosetting resin composition, except for the solvent, is 100%.

As compared to the prior art, the present invention has the following beneficial effects.

The present invention chooses an active ester having a styrene structure as the curing agent. When such active ester is used for curing epoxy resin, no polar group hydroxyl will be produced, so as to have excellent dielectric loss tangent. Meanwhile, such active ester has a styrene structure having a low polarity, and can further reduce the dielectric constant and water absorption of the cured active ester and thermosetting resin composition as compared with the active styrene containing no styrene structure in the background patents. Such active ester has multifunctionality, and may achieve a higher glass transition temperature after curing with epoxy resin, if the crosslinking density is suitable, so as to have excellent heat stability, humidity resistance and heat resistance. The thermosetting resin composition of the present invention has good heat stability, humidity and heat resistance, and low dielectric constant and dielectric loss angle tangent.

### Embodiments

In order to good explain the present invention and understand the technical solutions of the present invention, the typical but non-limitative examples of the present invention are provided as follows.

### Example 1

35 parts of an active ester 1 (m/n=8, produced by SHINA, SAP820) containing a styrene structure, 30 parts of HP7200, 15 parts of BT93, 20 parts of SC2050, 0.1 part of a catalyst 2-MI were dissolved in MEK, and modulated into a varnish having a suitable viscosity. 2116-electronic grade glass fabrics were infiltrated with the varnish, and placed in an oven at 155°C to remove solvent, to obtain a prepreg sample of B-stage. The sum of the mass parts of the active ester containing a styrene structure, HP7200, BT93 and SC2050 was 100 parts.

8 sheets of the prepreg and two sheets of electrolytic copper foil in an amount of 1 ounce were overlapped together, and laminated via a thermocompressor to obtain a double-faced copper-clad laminate. The lamination was carried out under the following conditions: 1. the temperature rising rate was controlled at 1.0-3.0 degree/min when the temperature of the materials was 80-120°C; 2. the pressure was 20kg/cm²; 3. the curing temperature was 190°C, and retained for 90 min. The corresponding properties are shown in Table 1.

### Example 2

50 parts of an active ester 1 (m/n=8, produced by SHINA, SAP820) containing a styrene structure, 25 parts of EPPN501H epoxy resin, 20 parts of SAYTEX8010 decabromo diphenylethane, 5 parts of kaolin, 0.075 part of a catalyst N,N-dimethyl-pyridylamine were dissolved in toluene, and modulated into a varnish having a suitable viscosity. Polyester non-woven fabrics were infiltrated with the varnish, and placed in an oven at 155°C to remove solvent, to obtain a prepreg sample of B-stage. The sum of the mass parts of the active ester containing a styrene structure, EPPN501H epoxy resin, decabromo diphenylethane and kaolin was 100 parts.

8 sheets of the prepreg and two sheets of electrolytic copper foil in an amount of 1 ounce were overlapped together, and laminated via a thermocompressor to obtain a double-faced copper-clad laminate. The lamination was carried out under the following conditions: 1. the temperature rising rate was controlled at 1.0-3.0 degree/min when the temperature of the materials was 80-120°C; 2. the pressure was 20kg/cm²; 3. the curing temperature was 190°C, and retained for 90 min. The corresponding properties are shown in Table 1.

### Example 3

60 parts of an active ester 1 (m/n=8, produced by SHINA, SAP820) containing a styrene structure, 30 parts of AG-80 epoxy resin, 10 parts of polytetrafluoroethylene powder, and 0.1 part of a catalyst butyltriphenyl chlorophosphine were dissolved in DMF, and modulated into a varnish having a suitable viscosity. 2116-electronic grade glass fabrics were infiltrated with the varnish, and placed in an oven at 155°C to remove solvent, to obtain a prepreg sample of B-stage. The sum of the mass parts of the active ester containing a styrene structure, AG-80 epoxy resin and polytetrafluoroethylene powder was 100 parts.

8 sheets of the prepreg and two sheets of electrolytic copper foil in an amount of 1 ounce were overlapped together, and laminated via a thermocompressor to obtain a double-faced copper-clad laminate. The lamination was carried out under the following conditions: 1. the temperature rising rate was controlled at 1.0-3.0 degree/min when the temperature of the materials was 80-120°C; 2. the pressure was 20kg/cm²; 3. the curing temperature was 190°C, and retained for 90 min. The corresponding properties are shown in Table 1.

### Example 4

30 parts of an active ester 2 (m/n=1) containing a styrene structure, 35 parts of N695, 15 parts of BT93 (ethylene-bis(tetrabromophthalimide)), 20 parts of SC2050, 0.1 part of a catalyst 2-MI (2-methylimidazole) were dissolved in MEK (butanone), and modulated into a varnish having a suitable viscosity. 2116-electronic grade glass fabrics were infiltrated with the varnish, and placed in an oven at 155°C to remove solvent, to obtain a prepreg sample of B-stage. The sum of the mass parts of the active ester containing a styrene structure, N695, BT93 and SC2050 was 100 parts.

8 sheets of the prepreg and two sheets of electrolytic copper foil in an amount of 1 ounce were overlapped together, and laminated via a thermocompressor to obtain a double-faced copper-clad laminate. The lamination was carried out under the following conditions: 1. the temperature rising rate was controlled at 1.0-3.0 degree/min when the temperature of the materials was 80-120°C; 2. the pressure was 20kg/cm²; 3. the curing temperature was 190°C, and retained for 90 min. The corresponding properties are shown in Table 1.

### Example 5

40 parts of an active ester 3 (m/n=6, produced by SHINA) containing a styrene structure, 25 parts of NC7700L, 15 parts of BT93, 20 parts of SC2050, 0.1 part of a catalyst 2-MI were dissolved in MEK, and modulated into a varnish having a suitable viscosity. 2116-electronic grade glass fabrics were infiltrated with the varnish, and placed in an oven at 155°C to remove solvent, to obtain a prepreg sample of B-stage. The sum of the mass parts of the active ester containing a styrene structure, HP7200, BT93 and SC2050 was 100 parts.

8 sheets of the prepreg and two sheets of electrolytic copper foil in an amount of 1 ounce were overlapped together, and laminated via a thermocompressor to obtain a double-faced copper-clad laminate. The lamination was carried out under the following conditions: 1. the temperature rising rate was controlled at 1.0-3.0 degree/min when the temperature of the materials was 80-120°C; 2. the pressure was 20kg/cm²; 3. the curing temperature was 190°C, and retained for 90 min. The corresponding properties are shown in Table 1.

### Example 6

15 parts of an active ester 4 (m/n=15) containing a styrene structure, 25 parts of HF-10, 25 parts of N695, 15 parts of HP3010, 20 parts of SC2050, 0.02 part of a catalyst 2-MI, and 0.1 part of zinc caprylate were dissolved in MEK, and modulated into a varnish having a suitable viscosity. 2116-electronic grade glass fabrics were infiltrated with the varnish, and placed in an oven at 155°C to remove solvent, to obtain a prepreg sample of B-stage. The sum of the mass parts of the active ester containing a styrene structure, HF-10, N695, HP3010 and SC2050 was 100 parts.

8 sheets of the prepreg and two sheets of electrolytic copper foil in an amount of 1 ounce were overlapped together, and laminated via a thermocompressor to obtain a double-faced copper-clad laminate. The lamination was carried out under the following conditions: 1. the temperature rising rate was controlled at 1.0-3.0 degree/min when the temperature of the materials was 80-120°C; 2. the pressure was 20kg/cm²; 3. the curing temperature was 190°C, and retained for 90 min. The corresponding properties are shown in Table 1.

### Comparison Example 1

3.5 parts of dicyandiamide, 96.5 parts of DER530, and 0.05 part of a catalyst 2-MI were dissolved in MEK, and modulated into a varnish having a suitable viscosity. 2116-electronic grade glass fabrics were infiltrated with the varnish, and placed in an oven at 155°C to remove solvent, to obtain a prepreg sample of B-stage. The sum of the mass parts of dicyandiamide and DER530 was 100 parts.

8 sheets of the prepreg and two sheets of electrolytic copper foil in an amount of 1 ounce were overlapped together, and laminated via a thermocompressor to obtain a double-faced copper-clad laminate. The lamination was carried out under the following conditions: 1. the temperature rising rate was controlled at 1.0-3.0 degree/min when the temperature of the materials was 80-120°C; 2. the pressure was 20kg/cm²; 3. the curing temperature was 190°C, and retained for 90 min. The corresponding properties are shown in Table 2.

### Comparison Example 2

75 parts of an active ester 5 (m/n=25) containing a styrene structure, 25 parts of DER530, and 0.1 part of a catalyst 2-MI were dissolved in MEK, and modulated into a varnish having a suitable viscosity. 2116-electronic grade glass fabrics were infiltrated with the varnish, and placed in an oven at 155°C to remove solvent, to obtain a prepreg sample of B-stage. The sum of the mass parts of active ester containing a styrene structure and DER530 was 100 parts.

8 sheets of the prepreg and two sheets of electrolytic copper foil in an amount of 1 ounce were overlapped together, and laminated via a thermocompressor to obtain a double-faced copper-clad laminate. The lamination was carried out under the following conditions: 1. the temperature rising rate was controlled at 1.0-3.0 degree/min when the temperature of the materials was 80-120°C; 2. the pressure was 20kg/cm²; 3. the curing temperature was 190°C, and retained for 90 min. The corresponding properties are shown in Table 2.

### Comparison Example 3

10 parts of an active ester 6 (m/n=0.5) containing a styrene structure, 10 parts of N695, 35 parts of DER530, 20 parts of SPB100, 25 parts of SC2050, and 0.1 part of a catalyst 2-MI were dissolved in MEK, and modulated into a varnish having a suitable viscosity. 2116-electronic grade glass fabrics were infiltrated with the varnish, and placed in an oven at 155°C to remove solvent, to obtain a prepreg sample of B-stage. The sum of the mass parts of active ester and N695 was 100 parts.

8 sheets of the prepreg and two sheets of electrolytic copper foil in an amount of 1 ounce were overlapped together, and laminated via a thermocompressor to obtain a double-faced copper-clad laminate. The lamination was carried out under the following conditions: 1. the temperature rising rate was controlled at 1.0-3.0 degree/min when the temperature of the materials was 80-120°C; 2. the pressure was 20kg/cm²; 3. the curing temperature was 190°C, and retained for 90 min. The corresponding properties are shown in Table 2.

### Comparison Example 4

25 parts of TD2090, 35 parts of N695, 15 parts of BT93, 20 parts of SC2050, 0.05 part of a catalyst 2-MI and zinc caprylate were dissolved in MEK, and modulated into a varnish having a suitable viscosity. 2116-electronic grade glass fabrics were infiltrated with the varnish, and placed in an oven at 155°C to remove solvent, to obtain a prepreg sample of B-stage. The sum of the mass parts of active ester, N695, BT93 and SC2050 was 100 parts.

8 sheets of the prepreg and two sheets of electrolytic copper foil in an amount of 1 ounce were overlapped together, and laminated via a thermocompressor to obtain a double-faced copper-clad laminate. The lamination was carried out under the following conditions: 1. the temperature rising rate was controlled at 1.0-3.0 degree/min when the temperature of the materials was 80-120°C; 2. the pressure was 20kg/cm²; 3. the curing temperature was 190°C, and retained for 90 min. The corresponding properties are shown in Table 2.

### Comparison Example 5

35 parts of HPC-8000-T65, 30 parts of HP7200, 15 parts of BT93, 20 parts of SC2050, and 0.1 part of a catalyst 2-MI were dissolved in MEK, and modulated into a varnish having a suitable viscosity. 2116-electronic grade glass fabrics were infiltrated with the varnish, and placed in an oven at 155°C to remove solvent, to obtain a prepreg sample of B-stage. The sum of the mass parts of HPC-8000-T65, HP7200, BT93 and SC2050 was 100 parts.

8 sheets of the prepreg and two sheets of electrolytic copper foil in an amount of 1 ounce were overlapped together, and laminated via a thermocompressor to obtain a double-faced copper-clad laminate. The lamination was carried out under the following conditions: 1. the temperature rising rate was controlled at 1.0-3.0 degree/min when the temperature of the materials was 80-120°C; 2. the pressure was 20kg/cm²; 3. the curing temperature was 190°C, and retained for 90 min. The corresponding properties are shown in Table 2.

The Chinese names and sources of the reagents involved in the following tables are as follows.

DER530 is bisphenol A brominated bifunctional epoxy resin from DOW

N695 is o-cresol novolac epoxy resin from DIC.

HP7200 is dicyclopentadiene epoxy resin from DIC.

NC7700L is naphthol novolac epoxy resin.

AG-80 is epoxy resin produced by Shanghai Institute of Synthetic Materials.

EPPON501H is trifunctional epoxy resin produced by NIPPON KAYAKU.

TD2090 is phenolic resin produced by DIC.

DICY is dicyandiamide produced by Ningxia Darong.

HF-10 is bisphenol A bifunctional cyanate produced by HUIFENG CHEMICAL ENGINEERING SCIENCE CO.

HPC-8000-T65 is active ester containing no styrene structure produced by DIC.

SC2050 is silica produced by Admatechs.

BT93 is ethylene-bis(tetrabromophthalimide) produced by Albemarle.

HP3010 is brominated polystyrene produced by Albemarle.

SPB100 is phosphazene flame retardant produced by Otsuka Chemical Co., LTD.

SAYTEX8010 is decabromo diphenylethane produced by Albemarle.

Kaolin is produced by BASF.

PTFE powder is produced by Shanghai 3F New Materials Co., Ltd.

The test standards and methods for the parameters in Tables 1 and 2 are as follows.

Glass transition temperature (Tg): tested with DSC according to the DSC testing method as stipulated under IPC-TM-650 2.4.25.

Peel strength: tested according to the experimental conditions "after the thermal stress" in the method of IPC-TM-650 2.4.8.

Dielectric constant and dielectric loss angle tangent: tested under 5 GHz according to SPDR.

Dip soldering resistance evaluation: impregnating copper-clad laminates in a solder machine at a temperature of 288°C for 20 seconds, taking out and cooling to room temperature, then repeatedly impregnating in the solder machine for 20 times, and evaluating the dip soldering property by observing the appearance thereof.

PCT water absorption test: impregnating copper-clad laminates in copper etching solution, removing the surface copper foil to evaluate the boards; placing the boards in a pressure cooker and treating at 121°C and 2atm for 2 h to test the water absorption of the boards.

PCT post dip-soldering evaluation: impregnating copper clad laminates in copper etching solution, removing the surface copper foil to evaluate the boards; placing the boards in a pressure cooker and treating at 121°C and 2atm for 2 h, impregnating in a soldering machine at 288°C, recoding the corresponding time when blistering or splitting appeared in the sheets; when there was no blistering or delamination after the sheets were in the soldering machine for 5 min, the evaluation may be ended.

Inflammability is tested according to the testing method of UL-94.

**Table 1**

| | Examples | | | | | |
|---|---|---|---|---|---|---|
| | 1 | 2 | 3 | 4 | 5 | 6 |
| N695 | | | | 35 | | 25 |
| HP7200 | 30 | | | | | |
| NC7700L | | | | | 25 | |
| AG-80 | | | 30 | | | |
| EPPON501H | | 25 | | | | |
| Active ester 1 containing a styrene structure | | | | 25 | | |
| Active ester 2 containing a styrene structure | 35 | 50 | 60 | | | |
| Active ester 3 containing a styrene structure | | | | | 40 | |
| Active ester 3 containing a styrene structure | | | | | | |
| Active ester 4 containing a styrene structure | | | | | | 15 |
| HF-10 | | | | | | 25 |
| SAYTEX8010 | | 20 | | | | |
| BT93 | 15 | | | 20 | 15 | |
| HP3010 | | | | | | 15 |
| SC2050 | 20 | | | 20 | 20 | 20 |
| Kaolin | | 5 | | | | |
| PTFE powder | | | 10 | | | |
| N,N-dimethyl-pyridylamine | | 0.075 | | | | |
| Butyltriphenyl-chlorophosphine | | | 0.1 | | | |
| Zinc naphthenate | | | | | | 0.02 |
| 2-MI | 0.1 | | | 0.1 | 0.1 | 0.1 |
| Toluene | | 80 | | | | |
| DMF | | | 80 | | | |
| MEK | 70 | | | 70 | 70 | 70 |
| Tg(°) | 175 | 192 | 183 | 182 | 185 | 208 |
| Dielectric constant | 3.85 | 3.7 | 3.6 | 3.9 | 3.8 | 3.7 |
| Dielectric loss angle tangent | 0.008 | 0.007 | 0.007 | 0.01 | 0.007 | 0.006 |
| Dip soldering resistance | good | good | good | good | good | good |
| Peel strength | 1.3 | 1.4 | 1.2 | 1.4 | 1.4 | 1.3 |
| PCT water absorption(%) | 0.25 | 0.28 | 0.27 | 0.28 | 0.27 | 0.26 |
| PCT post-dip soldering resistance (S) | >300 | >300 | >300 | >300 | >300 | >300 |
| Flame retardancy | V0 | V0 | V0 | V0 | V0 | V0 |

| | | | | | | |
|---|---|---|---|---|---|---|
| Notes: the content of each component is based on weight parts. | | | | | | |

**Table 2**

| | Comparison Examples | | | | |
|---|---|---|---|---|---|
| | 1 | 2 | 3 | 4 | 5 |
| DER530 | 96.5 | 25 | 35 | | |
| 7200 | | | | | 30 |
| N695 | | | 10 | 35 | |
| Active ester 5 containing a styrene structure | | 75 | | | |
| Active ester 6 containing a styrene structure | | | 10 | | |
| HPC-8000-T65 | | | | | 35 |
| TD2090 | | | | 25 | |
| DICY | 3.5 | | | | |
| BT93 | | | | 20 | 15 |
| SPB100 | | | 20 | | |
| SC2050 | | | 25 | 20 | 20 |
| 2-MI | 0.05 | 0.1 | 0.1 | 0.1 | 0.1 |
| MEK | 80 | 90 | 40 | 70 | 70 |
| Tg(°) | 135 | 133 | 165 | 170 | 172 |
| Dielectric constant | 4.6 | 3.6 | 4.15 | 4.5 | 4.15 |
| Dielectric loss angel tangent | 0.015 | 0.008 | 0.010 | 0.01 7 | 0.009 |
| Dip soldering resistance | blistering | delamin ation | blisterin g | good | good |
| Peel strength | 2.0 | 0.35 | 1.2 | 1.4 | 1.4 |
| PCT water absorption(%) | 0.40 | 0.35 | 0.31 | 0.29 | 0.29 |
| PCT post-dip soldering resistance (S) | 200 | 160 | 180 | >300 | >300 |
| Flame retardancy | V0 | V0 | V0 | V0 | V0 |

| | | | | | |
|---|---|---|---|---|---|
| Notes: the content of each component is based on weight parts. | | | | | |

It can be seen according to Table 1 that Examples 1-6 have a low dielectric constant and a low dielectric loss factor, and good heat resistance, dip soldering resistance, heat resistance and humidity resistance. On the other hand, Dicy was used in Comparison Example 1 to cure the epoxy resin, wherein the dielectric constant and dielectric loss angle tangent were too high; the glass transition temperature was too low; and the humidity and heat resistance is worse. Comparison Example 2 shows a low glass transition temperature and a low peel strength, and delamination appears during the humidity and heat resistance, and dip soldering resistance tests. Comparison Example 3 shows a too low glass transition temperature, a worse dip soldering resistance and a worse humidity and heat resistance (PCT post-dip soldering resistance delamination appears within 300s). As compared with Example 4, the sheets prepared by curing epoxy resin with phenolic aldehyde in Comparison Example 4 have a too high dielectric constant. As compared with Comparison Example 5, the sheets prepared by using an active ester containing a styrene structure in Example 1 have excellent dielectric constant and water absorption ability.

The applicant declares that, the present invention detailedly discloses the process of the present invention by the aforesaid examples, but the present invention is not limited by the detailed process, i.e. it does not mean that the present invention cannot be fulfilled unless the aforesaid detailed process is used. Those skilled in the art shall know that, any amendment, equivalent change to the product materials of the present invention, addition of auxiliary ingredients, and selection of any specific modes all fall within the protection scope and disclosure scope of the present invention.

## Claims

1. A thermosetting resin composition, **characterized in that** the thermosetting resin composition comprises an epoxy resin having two or more epoxy groups per resin molecule, and an active ester containing a styrene structure.

2. The thermosetting resin composition according to claim 1, **characterized in that** the active ester containing a styrene structure has the following structure: 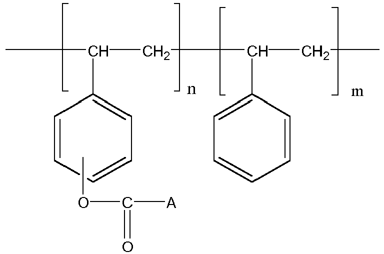 wherein A is selected from the group consisting of substituted or unsubstituted phenyl, substituted or unsubstituted naphthyl and C1-C8 alkyl group; m and n are natural numbers, wherein m/n=0.8-19.

3. The thermosetting resin composition according to claim 1, **characterized in that** the epoxy resin is one or a mixture of at least two selected from the group consisting of 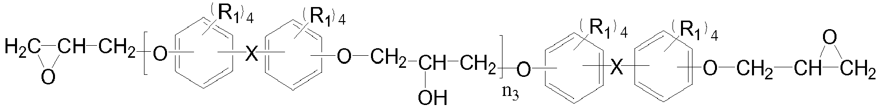 wherein R₁ is selected from the group consisting of hydrogen atom, halogen atom, substituted or unsubstituted C1-C8 linear-chain alkyl group, substituted or unsubstituted C1-C8 branched-chain alkyl group, substituted or unsubstituted alicyclic alkyl group, substituted or unsubstituted C1-C10 alkoxy group, and substituted or unsubstituted phenyl; n₃ is any natural number; X is anyone selected from the group consisting of -CH₂-, -O-, -CO-, -SO₂-, -S-, -CH(C₆H₅)-, -C(C₆H₅)₂-, -CH(CH₃)-, -C(CH₃)₂- or 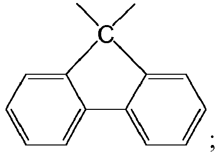 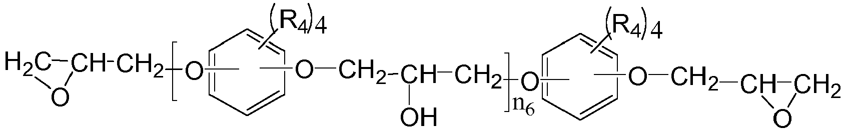 wherein R₄ is selected from the group consisting of hydrogen atom, halogen atom, substituted or unsubstituted C1-C8 linear-chain alkyl group, substituted or unsubstituted C1-C8 branched-chain alkyl group, substituted or unsubstituted alicyclic alkyl group, substituted or unsubstituted C1-C10 alkoxy group, and substituted or unsubstituted phenyl; n₆ is any natural number; and
phenol novolac epoxy resin, methyl phenol novolac epoxy resin, bisphenol-A novolac epoxy resin, dicyclopentadiene epoxy resin, biphenyl epoxy resin, resorcinol epoxy resin, naphthalene epoxy resin, phosphorous-containing epoxy resin, silicon-containing epoxy resin, glycidyl amine epoxy resin, alicyclic epoxy resin, polyethylene glycol epoxy resin, tetraphenol ethane tetraglycidyl ether, and triphenolmethane epoxy resin.

4. The thermosetting resin composition according to claim 1, **characterized in that** the epoxy resin is one or a mixture of at least two selected from the group consisting of 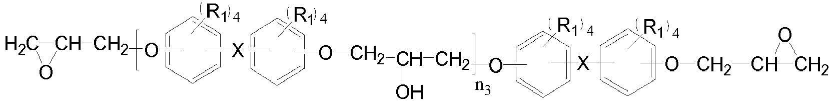 wherein R₁ is selected from the group consisting of hydrogen atom, halogen atom, substituted or unsubstituted C1-C8 linear-chain alkyl group, substituted or unsubstituted C1-C8 branched-chain alkyl group, substituted or unsubstituted alicyclic alkyl group, substituted or unsubstituted C1-C10 alkoxy group, and substituted or unsubstituted phenyl; n₃ is any natural number; X is anyone selected from the group consisting of -CH₂-, -O-, -CO-, -SO₂-, -S-, -CH(C₆H₅)-, -C(C₆H₅)₂-, -CH(CH₃)-, -C(CH₃)₂- or 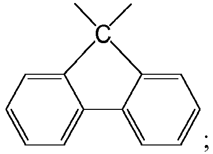 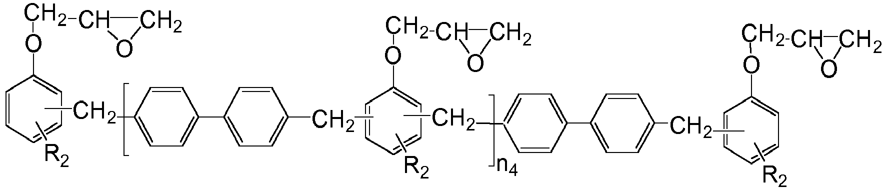 wherein R₂ is selected from the group consisting of hydrogen atom, halogen atom, substituted or unsubstituted C1-C8 linear-chain alkyl group, substituted or unsubstituted C1-C8 branched-chain alkyl group, substituted or unsubstituted alicyclic alkyl group, substituted or unsubstituted C1-C10 alkoxy group, and substituted or unsubstituted phenyl; 0≤n₄≤20, and n₄ is an integer; 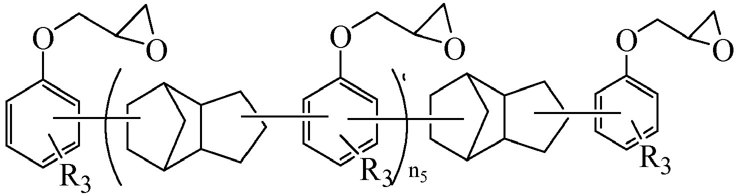 wherein R₃ is selected from the group consisting of halogen or hydrogen atom, substituted or unsubstituted C1-C8 linear-chain alkyl group, substituted or unsubstituted C1-C8 branched-chain alkyl group, substituted or unsubstituted alicyclic alkyl group, substituted or unsubstituted C1-C10 alkoxy group, and substituted or unsubstituted phenyl; 0≤n₅≤20, and n₅ is an integer; 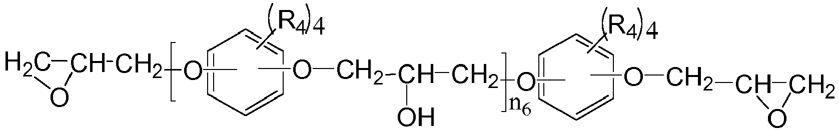 wherein R₄ is selected from the group consisting of hydrogen atom, halogen atom, substituted or unsubstituted C1-C8 linear-chain alkyl group, substituted or unsubstituted C1-C8 branched-chain alkyl group, substituted or unsubstituted alicyclic alkyl group, substituted or unsubstituted C1-C10 alkoxy group, and substituted or unsubstituted phenyl; n₆ is any natural number; and 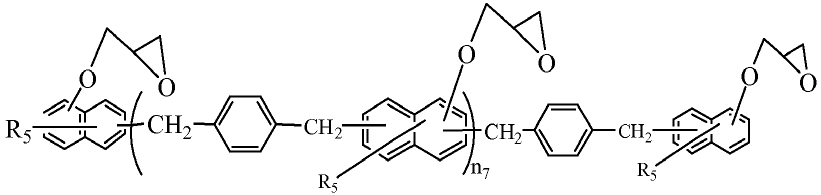 wherein R₅ is selected from the group consisting of hydrogen atom, halogen atom, substituted or unsubstituted C1-C8 linear-chain alkyl group, substituted or unsubstituted C1-C8 branched-chain alkyl group, substituted or unsubstituted alicyclic alkyl group, substituted or unsubstituted C1-C10 alkoxy group, and substituted or unsubstituted phenyl; 0≤n₇≤20, and n₇ is an integer.

5. The thermosetting resin composition according to any of claims 1-4, **characterized in that** the active ester containing a styrene structure is in an amount of from 11 to 70 wt.%, preferably from 15 to 65 wt.%, more preferably from 15 to 60 wt.% of the total weight of the thermosetting resin composition.

6. The thermosetting resin composition according to claim 1, **characterized in that** the thermosetting resin composition further comprises a flame retardant;
preferably, the flame retardant is selected from the group consisting of halogen flame retardant and phosphorous flame retardant;
preferably, the halogen flame retardant is one or a mixture of at least two selected from the group consisting of brominated phenol, brominated bisphenol A, decabromodiphenyl ether, brominated polystyrene, brominated polycarbonate, decabromodiphenylethane or ethylene-bis(tetrabromo- phthalimide);
preferably, the phosphorous flame retardant is one or a mixture of at least two selected from the group consisting of tri-(2,6-dimethylphenyl)phosphine, tetrakis(2,6-dimethylphenyl) 1,3-phenylene bisphosphate, tetraphenyl resorcinol diphosphate, triphenyl phosphate, bisphenolA-bis(diphenyl phosphate), phosphonitrile flame retardant, 10-(2,5-dihydroxylphenyl)-10-hydro-9-oxa-10-phosphaphenanthrene-10-oxide, 10-(2,5-dihydroxylnaphthyl)-10-hydro-9-oxa-10-phosphaphenanthrene-10-oxide or 9,10-dihydro-9-oxa-10-phosphaphenanthrene-10-oxide flame retardant;
preferably, the flame retardant is in an amount of from 5 to 30 wt.% of the mass of the thermosetting resin composition.

7. The thermosetting resin composition according to claim 1, **characterized in that** the thermosetting resin composition further comprises a filler;
preferably, the filler is anyone or a mixture of at least two selected from the group consisting of aluminium hydroxide, magnesium hydroxide, kaolin, talc, hydrotalcite, calcium silicate, beryllia, boron nitride, glass powder, silica powder, zinc borate, aluminium nitride, silicon nitride, silicon carbide, magnesium oxide, zirconium oxide, mullite, titanium oxide, potassium titanate, hollow glass beads, potassium titanate fibers, silicon carbide monocrystal fibers, silicon nitride fibers, aluminium oxide monocrystal fibers, glass short fibers, polytetrafluoroethylene powder, polyphenylene sulfide powder, and polystyrene powder;
preferably, the filler is in an amount of from 5 to 60 wt.% of the mass of the thermosetting resin composition;
preferably, the thermosetting resin composition further comprises a catalyst;
preferably, the catalyst is anyone or a mixture of at least two selected from the group consisting of tertiary amine, tertiary phosphine, quaternary ammonium salt, quaternary phosphonium salt or imidazole compound;
preferably, the tertiary amine is anyone or a mixture of at least two selected from the group consisting of triethylamine, tributylamine, dimethylaminoethanol, N,N-dimethyl-pyridylamine or benzyl- dimethylamine;
preferably, the tertiary phosphine is selected from the group consisting of triphenylphosphine and trialkylphosphine;
preferably, the quaternary ammonium salt is anyone or a mixture of at least two selected from the group consisting of tetramethyl ammonium bromide, tetramethyl ammonium chloride, tetramethyl ammonium iodide, benzyl trimethyl ammonium chloride, benzyl triethyl ammonium chloride or cetyltrimethyl ammonium bromide;
preferably, the quaternary phosphonium salt is anyone or a mixture of at least two selected from the group consisting of tetrabutylphosphonium chloride, tetrabutylphosphonium bromide, tetrabutyl- phosphonium iodide, tetraphenylphosphonium chloride, tetraphenylphosphonium bromide, tetraphenylphosphonium iodide, ethyltriphenylphosphonium chloride, propyltriphenylphosphonium chloride, propyltriphenylphosphonium bromide, propyltriphenylphosphonium iodide, butyltriphenylphosphonium chloride, butyltriphenylphosphonium bromide or butyltriphenylphosphonium iodide;
preferably, the imidazole compound is one or a mixture of at least two selected from the group consisting of 2-methylimidazole, 2-ethyl-4-methylimidazole, 2-phenylimidazole, 2-undecylimidazole, 1-benzyl-2- methylimidazole, 2-heptadecylimidazole, 2-isopropylimidazole, 2-phenyl-4- methylimidazole, 2-dodecylimidazole or cyanoethyl-2-methylimidazole;
preferably, the catalyst is in an amount of from 0.001 to 5.0 wt.% of the mass of the thermosetting resin composition;
preferably, the thermosetting resin composition further comprises a solvent selected from the group consisting of ketones, hydrocarbons, ethers or aprotic solvents, or a mixture of at least two selected therefrom;
preferably, the thermosetting resin composition further comprises one of or a mixture of at least two selected from the group consisting of polyphenylether, cyanate resin or BT resin;
preferably, the cyanate resin is prepared from anyone or a mixture of at least two selected from the following monomers, from anyone or a mixture of at least two selected from the prepolymers of the following monomers, or a mixture of at least two selected therefrom: bisphenol A cyanate, 2,2-di(cyanatephenyl)-propane, di(cyanatephenyl)ethane, di(cyanatephenyl)methane, di(4-cyanate-3,5-dimethylphenyl)methane, 2,2-di(4-cyanatephenyl)hexafluoropropane, di(4-cyanate-phenyl)thioether, novolac cyanate or cyanate containing dicyclopentadiene structure;
preferably, the thermosetting resin composition further comprises anyone or a mixture of at least two selected from the group consisting of dyes, pigments, surfactants, flatting agents and ultraviolet light absorbers.

8. A resin sheet, resin composite metal foil, or prepreg prepared from the thermosetting resin composition according to any of claims 1-7.

9. A laminate or metal foil-clad laminate prepared from the resin sheet, resin composite metal foil, or prepreg according to claim 8.

10. A printed wiring board prepared from the resin sheet, resin composite metal foil, or prepreg according to claim 8.
